(19) Europäisches Patentamt
European Patent Office
Office européen des brevets

(11) Numéro de publication: **0 287 810 B1**

(12) **FASCICULE DE BREVET EUROPEEN**

(45) Date de publication de fascicule du brevet: **15.01.92**

(51) Int. Cl.5: **H01L 39/12**, H01L 39/24

(21) Numéro de dépôt: **88104335.0**

(22) Date de dépôt: **18.03.88**

# (54) Oxyde de cuivre a valence mixte supraconducteur et son procede de mise en oeuvre.

(30) Priorité: **19.03.87 FR 8703847**

(43) Date de publication de la demande: **26.10.88 Bulletin 88/43**

(45) Mention de la délivrance du brevet: **15.01.92 Bulletin 92/03**

(84) Etats contractants désignés: **AT BE CH DE ES FR GB GR IT LI LU NL SE**

(56) Documents cités:

**SCIENCE, vol. 235, 13 mars 1987, pages 1373-1376, Lancaster, US; J.M. TARASCON et al.: "Superconductivity at 40 K in the Oxygen-defect perovskites La2-xSrxCuO4-y"**

**PHYSICAL REVIEW LETTERS, vol. 58, no. 4, 26 janvier 1987, pages 408-410, The American Physical Society, New York, US; R.J. CAVA et al.: "Bulk Superconductivity at 36 K in La1.8Sr0.2CuO4"**

(73) Titulaire: **ALCATEL ALSTHOM COMPAGNIE GENERALE D'ELECTRICITE**
**54, rue La Boétie**
**F-75382 Paris Cédex 08(FR)**

(72) Inventeur: **Deslandes, Francis**
**Route de Danzé Saint Ouen**
**F-41100 Vendome(FR)**
Inventeur: **Michel, Claude**
**1 allée des Epis**
**F-14200 Herouville Saint Clair(FR)**
Inventeur: **Provost, Jackie**
**1 Rue des Hauts Marquets Villons les Buissons**
**F-14610 Thaon(FR)**
Inventeur: **Raveau, Bernard**
**25 Allèe Guillaume le Conquérant**
**F-14112 Beuville(FR)**
Inventeur: **Sulpice, André Centre de Recherches**
**sur les très basses températures**
**Avenue des Martyrs 38000 Grenoble(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).



Rank Xerox (UK) Business Services

**APPLIED PHYSICS LETTERS, vol. 50, no. 9, 2 mars 1987, pages 543-544, American Institute of Physics; D.W. CAPONE et al.: "Upper critical fields and high superconducting transition temperatures of La1.85Sr0.15CuO4 and La1.85Ba0.15CuO4"**

**ZEITSCHRIFT FÜR PHYSIK B, vol. 66, no. 2, 1987, pages 141-146, Springer Verlag, Berlin, DE; C. POLITIS et al.: "Superconductivity at 40 K in La1.8Sr0.2CuO4"**

Inventeur: **Tholence, Jean-Louis Centre de Recherches**
**sur les très basses températures**
**Avenue des Martyrs 38000 Grenoble(FR)**
Inventeur: **Chevalier, Bernard**
**Résidence Lahire App. 65C**
**Rue Henri de Montherlant F-33400**
**Talence(FR)**

(74) Mandataire: **Weinmiller, Jürgen et al**
**Lennéstrasse 9 Postfach 24**
**W-8133 Feldafing(DE)**

## Description

L'invention se rapporte à un oxyde de cuivre à valence mixte et à son procédé de mise en oeuvre.

Jusqu'en 1986, le phénomène de supraconductivité était limité au domaine des très basses températures, et plus particulièrement à l'utilisation de l'hélium liquide. Le record de température critique observé était de 23,3 K pour $Nb_3Ge$ élaboré en couches minces. En dépit de ce handicap, les matériaux supraconducteurs étaient appelés à connaître des applications nombreuses en électrotechnique, en particulier dans la réalisation d'électroaimants en vue d'obtenir des champs magnétiques intenses. Ces possibilités ont été longuement renforcées avec la découverte vers 1970 des chalcogénures ternaires supraconducteurs, notamment étudiés pour leur champ critique élevé.

Sur le plan des connaissances fondamentales, des progrès importants ont été accomplis en physique du solide ces dernières années non seulement en ce qui concerne les interactions entre la supraconductivité et le magnétisme dans les chalcogénures ternaires, mais aussi dans le domaine des matériaux organiques supraconducteurs.

L'étude des oxydes de cuivre à valence mixte dérivées de la pérovskite à été engagée depuis quelques années par le laboratoire CRISMAT de l'Université de Caen dans le cadre de nouveaux oxydes à propriétés métalliques anisotropes. Cette étude a montré que la réalisation de tels matériaux nécessite deux conditions quant à la nature de l'élément M constituant le réseau d'accueil $MO_n$ de l'oxyde :

- L'élément M doit être susceptible de présenter une valence mixte soit donc deux états d'oxydation simultanément. Ce sera donc un élément de transition favorable à la délocalisation des électrons dans une bande construite à partir des orbitales $dx^2 - y^2$ et $dz^2$ de l'élément métallique et des orbitales 2p des atomes d'oxygène par LCAO ("Linear Combination Atomic Orbitals") ;
- Il devra pour introduire l'anisotropie être capable de réaliser à lui seul une charpente mixte donc prendre plusieurs coordinences simultanément.

C'est dans cette optique que le cuivre a été considéré comme un candidat potentiel en raison de ses deux états d'ionisation possibles : l'ion $Cu^{3+}$ caractérisé par son aptitude à la coordinence octaétrique, et l'ion $Cu^{2+}$ dont l'effet Jahn Teller permet les coordinences octaédrique, pyramidale et carrée.

Pour la réalisation de structures anisotropes, la charpente pérovskite est intéressante en raison de sa grande simplicité, puisqu'elle est formée uniquement d'octaèdres joints par les sommets. De cette façon, on pouvait espérer synthétiser des pérovskites déficitaires en oxygène par création de lacunes anioniques de façon ordonnée.

Un article de Ninh Nguyen, Jacques Choisnet, Maryvonne Hervieu et Bernard Raveau de ce laboratoire de Caen, intitulé "Oxygen defect $K_2NiF_4$

- type oxydes : The compound $La_{2-x}$ $Sr_x$ $CuO_{4-(x/2)+\delta}$ " paru dans "Journal of solid state chemistry 39, 120-27, 1981 est à l'origine de toute cette famille structurale. Il résulte de l'intercroissance de feuillets pérovskites déficitaires en oxygène et de feuillets stoéchiométriques de type SrO isolant. Les premiers, caractérisés par des feuillets pérovskites simples isolés par des couches type SrO, sont de véritables conducteurs bidimensionnels dans lesquels les lacunes anioniques sont situées dans le plan de base de l'octaèdre $CuO_6$.

Comme décrit dans l'article intitulé "Oxydes ternaires de cuivre à valence mixte de type $K_2NiF_4$ déficitaires en oxygène : évolution progressive d'un état conducteur vers un état semi-métallique des oxydes $La_{2-x}$ $Sr_x$ Cu $O_{4-(x/2)+\delta}$ " de N. Nguyen, F. Studer et B. Raveau paru dans "Physs-chem. Solids" vol. 44 N° 5 pages 389-400, 1983, les oxydes ternaires de cuivre à valence mixte dérivés de type $K_2NiF_4$ sont caractérisés par des taux de lacunes importants qui couvrent sur le plan des propriétés électriques un grand domaine allant d'un état semi-conducteur à un état semi-métallique, suivant la pression d'oxygène à laquelle ils sont soumis. Les résultats ainsi obtenus, ainsi que ceux obtenus précédemment dans le cas des oxydes $La_3Ba_3$ $Cu_6$ $O_{14+y}$ et $La_{2-x}$ $Sr_x$ Cu $O_{4-(x/2)+\delta}$ , montrent que de telles propriétés peuvent être généralisées à de nombreux oxydes ternaires de cuivre caractérisés par une structure dérivant de la perovskite soit par création de lacunes soit par intercroissance. Les propriétés électriques des oxydes $La_{2-x}$ $A_x$ Cu $O_{4-x/2+\delta}$ notamment dans le cas des composés du strontium entre 100 K et 300 K font apparaître pour des taux de substitution faibles ( $x < 0,3$) des conductivités métalliques à température ordinaire de deux ordres de grandeur supérieures à celles de l'oxyde $La_2$ Cu $O_4$.

C'est en étudiant la supraconductivité dans les oxydes de composition Ba $La_{5-x}$ $Cu_5$ $O_{5(3-y)}$ que deux physiciens suisses Bednorz et Muller ont mis en évidence une transition résistive à 30 K dont la température est réduite par l'application de courants de mesure de haute densité. Dans un article intitulé "Possible high Tc Superconductivity in the Ba-La-Cu-O System" ( Z. Phys. B, Condensed matter, 64, 189-193, 1986), ils considèrent des composés métalliques déficitaires en oxygène dans le système Ba-La-Cu-O, avec la composition $Ba_x$ $La_{5-x}$ $Cu_5$ $O_{5(3-y)}$ préparés sous forme polycristalline. Des échantillons avec x = 1 et 0,75, y > 0, recuits sous 900 °C dans des conditions réductrices, consistent en trois phases dont l'une est un composé du cuivre à valence mixte de type perovskite. Sous refroidissement les échantillons montrent une décroissance linéaire en résistivité, puis une décroissance pratiquement logarithmique, interprétée comme un début de localisation. Finalement une décroissance brusque jusqu'à trois ordres d'amplitude se produit, évoquant la transition de supraconductivité percolative. la plus haute température de transition est observée dans la gamme 30 K. Celle-ci est notablement réduite pour des densités de courant élevées. Les auteurs estiment que ces propriétés résultent ainsi partiellement de la nature percolative, mais peut-être aussi de fluctuations supraconductives 2D des couches perovskites doubles d'une des phases présentes.

Ainsi les oxydes supraconducteurs à température critique Tc élevée ont été découverts très récemment. Le chef de file en est l'oxyde $La_{2-x}$ $Sr_x$ Cu $O_{4-y}$ dont les propriétés supraconductrices ont été décrites par R.J. Cava, R.B. Van Dover, B. Batlogg et E.A. Rietman, dans un article intitulé "Bulk superconductivity at 36 K in $La_{1,8}$ $Sr_{0,2}$ Cu $O_4$ ("Physical Review Letters", volume 58, Numéro 4, 26 janvier 1987). Cet article décrit le résultat de mesures de résistivité et de susceptibilité magnétique pour le composé $La_{2-x}$ $Sr_x$ Cu $O_4$ avec $x \leqq 0,3$. L'échantillon x = 0,2 montre une transition supraconductrice à 36,2 K avec une largeur de 1,4 K. La susceptibilité diamagnétique dc associée (effet Meissner) atteint une fraction élevée (60%-70%) de la valeur idéale. les auteurs estiment la densité des états à partir du champ critique et des valeurs de résistivité, et suggèrent, par analogie avec le composé Ba $Pb_{1-x}$ $Bi_x$ $O_3$, que la supraconductivité conventionnelle peut justifier la haute température critique dans cette classe de matériaux.

La présente invention a pour objet d'améliorer ces caractéristiques, notamment en ce qui concerne la température critique Tc et/ou les courants critiques, et la température de frittage.

Elle propose à cet effet un oxyde de cuivre à valence mixte supraconducteur, caractérisé en ce qu'il a une formule du type

$(La_{2-x}\ (Y_{x''}\ Bi_{1-x''})_{x'},\ Sr_{x-x'})_{1-\epsilon}$ Cu $O_{4-y}$

$0 < x \leqq 0,3$
$0 < x' \leqq 0,2$ avec $x' < x$
$0 \leqq x'' \leqq 1$
$0 < y \leqq 0,1$
$0 \leqq \epsilon \leqq 0,05$

De tels composés apportent sur le plan technologique des progrès considérables aussi bien dans le domaine de l'électrotechnique, et particulièrement dans la réalisation des aimants où ils pourraient être utilisés sous forme de fils, que dans le domaine de l'électronique, où la réalisation de couches minces peut devenir un enjeu très important.

La substitution du Lanthane par le Bismuth permet

- d'améliorer les propriétés supraconductrices des phases,
- et d'abaisser la température de frittage afin de faciliter l'élaboration des céramiques et éventuellement l'étirage de fils.

L'invention propose également un procédé de mise en oeuvre de tels matériaux.

Les caractéristiques et avantages de l'invention ressortiront d'ailleurs de la description qui va suivre, à titre d'exemple non limitatif, en référence aus figures annexées sur lesquelles

- les figures 1 à 3 représentent des courbes illustrant les caractéristiques des matériaux selon l'invention.

Les oxydes $La_{2-x}$ $Bi_{x'}$ $Sr_{x-x'}$ Cu $O_{4-y}$ ont été synthétisés par action des oxydes $La_2$ $O_3$, $Bi_2$ $O_3$ et Cu O et du carbonate de Strontium par frittage sous air à des températures comprises entre 950 °C et 1000 °C.

Les produits frittés sont recuits sous air, ou sous oxygène à 400 °C, on obtient des propriétés supraconductrices avec

$0 \leqq x \leqq 0,3$
$0 \leqq x' \leqq 0,2$ et $x' < x$
$0 < y \leqq 0,1$

L'oxyde $La_{1,7}$ $Bi_{0,1}$ $Sr_{0,2}$ Cu $O_{4-y}$ peut être considéré comme un excellent supraconducteur avec une température critique : Tc ≃ 42 K et pouvant supporter des courants critiques relativement élevés: On arrive en effet à une conservation de l'état supraconducteur jusqu'à des densités de courant égales à 10 A/cm$^2$. La figure 1 représente une courbe relative à un tel composé avec : Tc = 42 K ; i mesure = 0,5 mA ; R (290 K) = 0,26Ω , soit une résistivité $\rho$ (290 K) = 7,4.10$^{-3}$ Ωcm.

Pour x > 0,3 des températures critiques plus élevées peuvent être obtenues mais l'effet supraconducteur n'est pas stable.

Ainsi pour le composé $La_{1,6}$ $Bi_{0,1}$ $Sr_{0,3}$ Cu $O_{4-y}$ une transition résistive commençant vers 100 K et se terminant vers 80 K a été observée. Celle-ci disparait après plusieurs cycles de mesure.

Les oxydes $La_{2-x}$ $Y_{x'}$ $Sr_{x-x'}$ Cu $O_{4-y}$ ont été synthétisés par l'action des oxydes $La_2$ $O_3$, $Y_2$ $O_3$, CuO et du carbonate de Strontium par frittage sous air à 1050 °C, puis refroidissement lent sous oxygène à une vitesse de 30 °C/h.

Des propriétés très voisines de celles observées pour les phases au bismuth ont été observées. Le domaine correspondant est très voisin

$0 \leqq x \leqq 0,30$
$0 \leqq x' \leqq 0,20$ avec $x' < x$
$0 < y \leqq 0,1$

Ainsi les phases $La_{1,75}$ $Y_{0,05}$ $Sr_{0,2}$ Cu $O_{4-y}$ et $La_{1,70}$ $Y_{0,10}$ $Sr_{0,2}$ Cu $O_{4-y}$ sont caractérisées par une température critique de 46 K. Ces matériaux supportent des densités de courants de 4 A/cm$^2$ à 30 K, la figure 2 représente une courbe relative au composé $La_{1,7}$ $Y_{0,10}Sr_{0,2}$ Cu $O_{4-y}$ avec Tc = 46 K ; i (mesure) = 1mA ; R (290 K) = 0,21Ω , soit $\rho$ (290 K) = 2.10$^{-2}$ Ωcm.

Des oxydes $La_{2-x}$ $(Y_{x''}$ $Bi_{1-x''})_{x'}$ $Sr_{x-x'}$ Cu $O_{4-y}$

$0 \leqq x'' \leqq 1$

$0 \leqq x \leqq 0{,}30$

$0 \leqq x' \leqq 0{,}20$ avec $x' < x$

$0 < y \leqq 0{,}1$

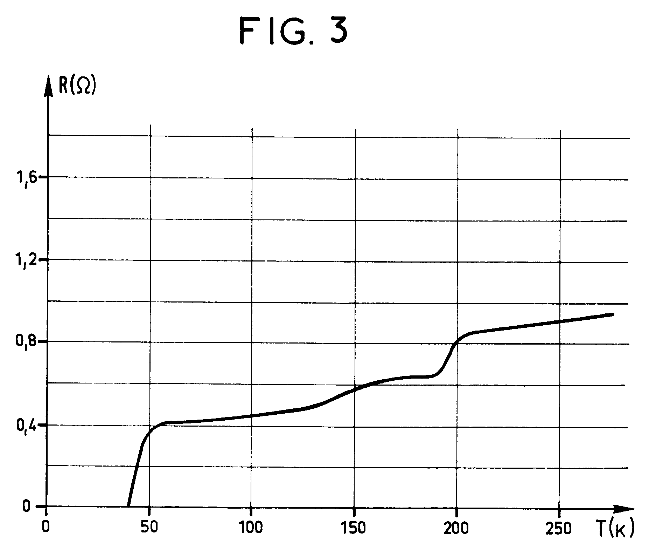

ont été obtenus par un procédé de synthèse identique à celui considéré pour l'obtention de composés du type $La_{2-x}$ $Bi_{x'}$ $Sr_{x-x'}$ Cu $O_{4-y}$. La figure 3 représente une courbe relative à un composé $La_{1,7}$ $Bi_{0,05}$ $Y_{0,05}$ $Sr_{0,2}$ Cu $O_4$ avec ℓ (290 K) = 7,4 x 10$^{-3}$ Ωcm.

Il faut souligner qu'avec des composés du type décrit précédemment, la température de frittage est notablement abaissée jusqu'à 950-1000 °C et que la densification des matériaux est bien meilleure du fait de la présence de Bismuth dans le matériau.

La supraconductivité en volume peut être notablement améliorée en faisant varier la stoechéométrie à savoir le rapport :

$$= \frac{La + Bi + Y + Sr}{Cu} = 2\ (1-\varepsilon\ ).$$

Suivant les conditions opératoires on obtient donc la formulation générale :

$(La_{2-x}$ $(Y_{x''}$ $Bi_{1-x''})_{x'}$ $Sr_{x-x''})_{1-\epsilon}$ Cu $O_{4-y}$

avec $O \leqq \epsilon \leqq 0{,}05$

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

## Revendications

1. Oxyde de cuivre à valence mixte supraconducteur, caractérisé en ce qu'il a une formule du type :

   $(La_{2-x}$ $(Y_{x''}$ $Bi_{1-x''})_{x'}$ $Sr_{x-x'})_{1-\epsilon}$ Cu $O_{4-y}$

   $0 < x \leqq 0{,}3$
   $0 < x' \leqq 0{,}2$ avec $x' < x$
   $0 \leqq x'' \leqq 1$
   $0 < y \leqq 0{,}1$
   $0 \leqq \epsilon \leqq 0{,}05$

2. Procédé de mise en oeuvre de l'oxyde de cuivre selon la revendication 1, caractérisé en ce que cet oxyde est synthétisé par action des oxydes $La_2$ $O_3$, $Bi_2$ $O_3$ et Cu O et du carbonate de Strontium par frittage sous air à des températures comprises entre 950 °C et 1000 °C.

3. Procédé selon la revendication 2, caractérisé en ce que les produits frittés sont recuits sous air, ou sous oxygène à 400 °C.

4. Procédé de mise en oeuvre de l'oxyde de cuivre selon la revendication 1, caractérisé en ce que cet oxyde est synthétisé par action des oxydes $La_2$ $O_3$,$Y_2O_3$ et Cu O et du carbonate de Strontium par frittage sous air à 1050 °C, puis refroidissement lent sous oxygène à une vitesse de 30 °C/h.

## Claims

1. A superconducting mixed valence copper oxide, characterized in that it has a formula of the type:

   $(La_{2-x}\ (Y_{x''}\ Bi_{1-x''})_{x'}Sr_{x-x'})_{1-\epsilon}Cu0_{4-Y}$

   $0 < x < 0{,}3$
   $0 < x' \leq 0{,}2$ with $x' < x$
   $0 < x'' \leq 1$
   $0 \leq y \leq 0{,}1$
   $0 < \epsilon \leq 0{,}05.$

2. A method of making the copper oxide of claim 1, characterized in that said oxide is synthesized by reacting the oxides $La_2O_3$, $Bi_2O_3$, and CuO with Strontium carbonate, by sintering in air at a temperature lying in the range 950 °C to 1000 °C.

3. A method according to claim 2, characterized in that the sintered products are annealed in air or in oxygen at 400 °C.

4. A method of making the copper oxide of claim 1, characterized in that said oxide is synthesized by reacting the oxides $La_2O_3$, $Y_2O_3$, and CuO with Strontium carbonate by sintering in air at a temperature of 1050 °C and then cooling slowly in oxygen at a speed of 30 °C/h.

## Patentansprüche

1. Supraleitendes Kupferoxid mit gemischter Valenz, dadurch gekennzeichnet, daß es eine

Formel des nachstehenden Typs besitzt:

$$(La_{2-x}(Y_{x''}Bi_{1-x''})_{x'}Sr_{x-x'})_{1-\epsilon}CuO_{4-y}$$

$0 < x \leq 0{,}3$
$0 < x' \leq 0{,}2$ mit $x' < x$
$0 \leq x' \leq 1$
$0 < y \leq 0{,}1$
$0 \leq \epsilon \leq 0{,}05$.

**2.** Verfahren zur Herstellung des Kupferoxids nach Anspruch 1, dadurch gekennzeichnet, daß das Oxid durch Reaktion der Oxide $La_2O_3$, $Bi_2O_3$ und CuO mit Strontiumkarbonat durch Sintern in Luft bei Temperaturen zwischen 950 °C und 1000 °C synthetisiert wird.

**3.** Verfahren nach Anspruch 2, dadurch gekennzeichnet, daß die gesinterten Produkte in Luft oder in Sauerstoff bei 400 °C wärmebehandelt werden.

**4.** Verfahren zur Herstellung des Kupferoxids nach Anspruch 1, dadurch gekennzeichnet, daß das Oxid durch Reaktion der Oxide $La_2O_3$, $Y_2O_3$ und CuO mit Strontiumkarbonat durch Sintern in Luft bei 1050 °C und anschließende langsame Abkühlung in Sauerstoff bei einer Geschwindigkeit von 30 °C/h synthetisiert wird.

FIG. 1

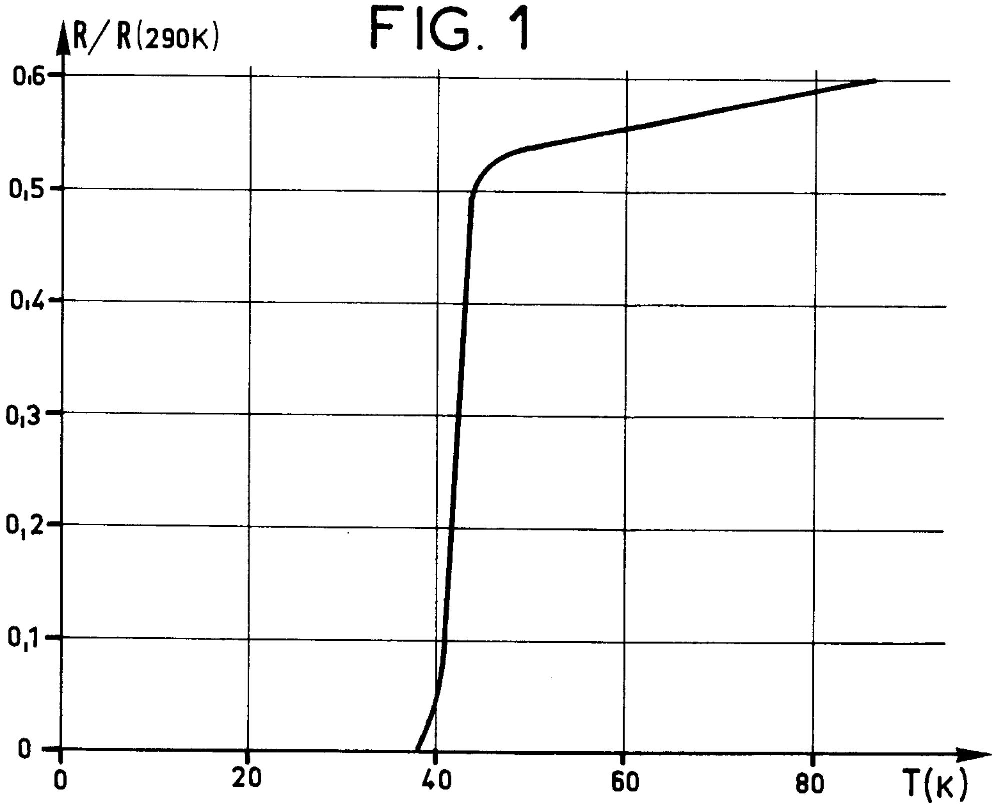
R/R(290K)
0,6
0,5
0,4
0,3
0,2
0,1
0
0
20
40
60
80
T(K)

FIG. 2

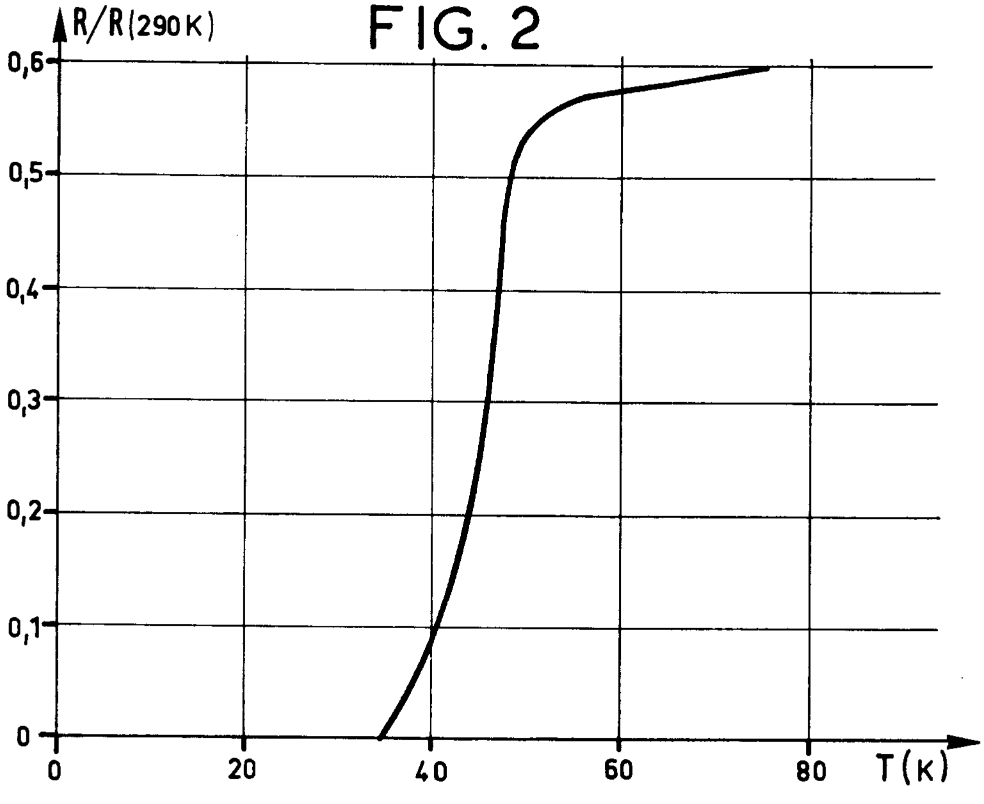
R/R(290K)
0,6
0,5
0,4
0,3
0,2
0,1
0
0
20
40
60
80
T(K)

FIG. 3